Europäisches Patentamt

European Patent Office

Office européen des brevets

(11) Publication number: **0 181 054**
**B1**

## EUROPEAN PATENT SPECIFICATION

(45) Date of publication of patent specification: **20.09.89**

(51) Int. Cl.⁴: **G 01 R 15/02**

(21) Application number: **85303896.6**

(22) Date of filing: **03.06.85**

(54) Line mounted apparatus for measuring line potential.

(30) Priority: **08.11.84 US 669589**

(43) Date of publication of application:
**14.05.86 Bulletin 86/20**

(45) Publication of the grant of the patent:
**20.09.89 Bulletin 89/38**

(84) Designated Contracting States:
**AT BE CH DE FR GB IT LI LU NL SE**

(56) References cited:
**EP-A-0 125 050**
**EP-A-0 125 796**
**US-A-3 428 896**
**US-A-4 384 289**

(73) Proprietor: **NIAGARA MOHAWK POWER
CORPORATION
300 Erie Boulevard West
Syracuse New York 13202 (US)**

(72) Inventor: **Montgomery, John Richard
715 Sasco Hill Road
Fairfield Connecticut 06430 (US)**
Inventor: **Smith-Vaniz, William Reid
14 Pasture Lane
Darien Connecticut 06820 (US)**

(74) Representative: **Blatchford, William Michael
et al
Withers & Rogers 4 Dyer's Buildings Holborn
London EC1N 2JT (GB)**

EP 0 181 054 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to apparatus for measuring a parameter of an above ground power line conductor comprising an electrically conductive housing attached to said above ground conductor, and mounting means for attaching said housing to said conductor.

More particularly, this invention relates to the measurement of high power, alternating current (AC), transmission line voltages, employing power line mounted radio transmitting electrically isolated modules, preferably mounted on all power conductors connected to the load to be monitored.

Each module is a separate measuring apparatus and contains the means for measuring the instantaneous voltage associated with the power conductor upon which the module is installed.

US-A-3428 896 describes such a measuring apparatus for measuring current flow in a high voltage A.C. conductor. In this arrangement the measurement is carried out by making connections to the conductor at two points and the voltage drop across this section is measured in order to provide a signal for modulating a carrier frequency transmitted from the conductive housing as an antenna. This apparatus cannot however measure the conductor voltage. Previously this parameter has been measured by the use of stepdown isolation voltage transformers where one end of the primary high voltage winding was conductively coupled to the power line conductor. However this technique exposes the measuring apparatus to high voltage stresses, especially when hit by lightening strikes due to the direct conductive link between the high voltage passing through the power line conductor and ground. The continual exposure to such high voltage stresses necessitated bulky and therefore expensive construction of such voltage measuring equipment to assure reliable operation and operator safety over extended periods of time.

In order to overcome this technical problem the apparatus of the present invention is characterised in that said mounting means includes a first conductive portion in electrical contact with said conductor, and a second conductive portion in electrical contact with said housing, and electrical insulating means separating said first and second portions, said apparatus including low impedance current measuring means, said measuring means electrically connected to said first conductive portion and to said housing whereby said housing acts as a charge collecting plate and said measuring means measure current flowing from said conductor to said housing, said current being proportional to the voltage on said power line conductor. The measured instantaneous voltage is derived from the potential difference induced by the electric field associated with the power line upon the outer toroidal structure of the module.

The novel voltage measuring apparatus disclosed herein makes possible the use of the module as a hot stick mounted power line voltage probe.

It is desirable to measure potential values along the power line for short periods or continually at arbitrary positions. This measured voltage can be used to derive Fourier frequency components, power, and power factor information associated with the operation of the power line being measured, and to locate and diagnose anomalies in the use and transmission of electric power.

The configuration of the invention avoids requirements for bulky insulation to accommodate the high voltages associated with power line operation. This is accomplished in preferred embodiments by the interposition of a radio link instead of the typical direct conductive connection to ground from the power line.

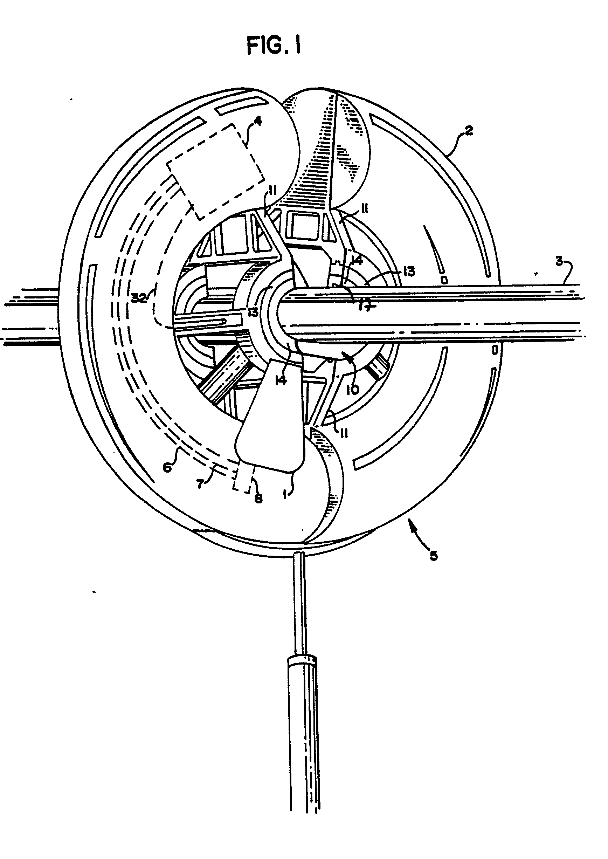

The preferred embodiment of the voltage measuring system shown in Figure 1 has no direct, highly conductive link between the high voltage of the power line 3 and ground through the measuring device. The voltage measurement is encoded and transmitted via radio frequency energy from the measuring device, namely a toroidal state estimator module 5, to a ground receiver separated by an air gap sufficiently large to avoid any high voltage stress conditions on the measuring circuits from the large potential difference between the power line and ground.

The power line voltage measurement is obtained from measuring the leakage or charging current created by the interaction of the alternating electric field created by the high voltage in the power line with the essentially toroidal structure of the outer surface of the module 5. The fixed spacial relationship of the module with respect to the ground plane determines the value of the leakage or charging current.

The outer shell 2 of the module is kept at some intermediate potential between the power line voltage and ground because of its geometry and spacial relationship to the ground plane. The potential of the outer shell 2 is forced to be within a fraction of a volt from the power line voltage by the effect of the electronic circuits within the module.

The leakage current flowing from the outer surface of the toroidal module to ground is essentially proportional to the potential difference between the power line and ground. Since the outer shell of module 5 is nearly at the same voltage as power conductor 3, any change in voltage in conductor 3 will be reflected as a change in charging current flowing from module 5 to ground.

Therefore, a prior knowledge of the ratio of change in charging current with respect to change in power line voltage will allow the circuits of the module to transform the measured leakage current into an accurate power line voltage reading.

In an earlier proposal EP-A-0 125 796 (published 21. 11. 1984) we provided long arcuate capacitor plates embedded in and electrically isolated from the skin of the donut shaped module. We have found this configuration somewhat susceptible to variation in measurements caused by varying weather conditions, particularly rain and snow. Reference is also made to EP-A-0 125 050 (published 14. 11. 1984)

In the apparatus disclosed in this application we have largely overcome these problems by utilizing the entire torodial case as a charge collecting, capacitor plate. Furthermore, we have DC isolated the toroidal case from the power line conductor by applying a thin hard ceramic coating on the jaws insert. Across this layer of insulation are the inputs to an integrating operational amplifier so configured as to present a very low input impedance across the hard ceramic coating and maintain the voltage difference between the two insulated sides within a fraction of a volt of each other. The current flowing from the power line through to the outer skin of the module is forced to pass through the operational amplifier, digitized, and reported as a voltage measurement.

For a fuller understanding of the nature and objects of the invention, reference should be had to the following detailed description taken in connection with the accompanying drawings, in which:

Figure 1 is a perspective view of apparatus according to the invention for measuring the potential difference between a power conductor and ground;

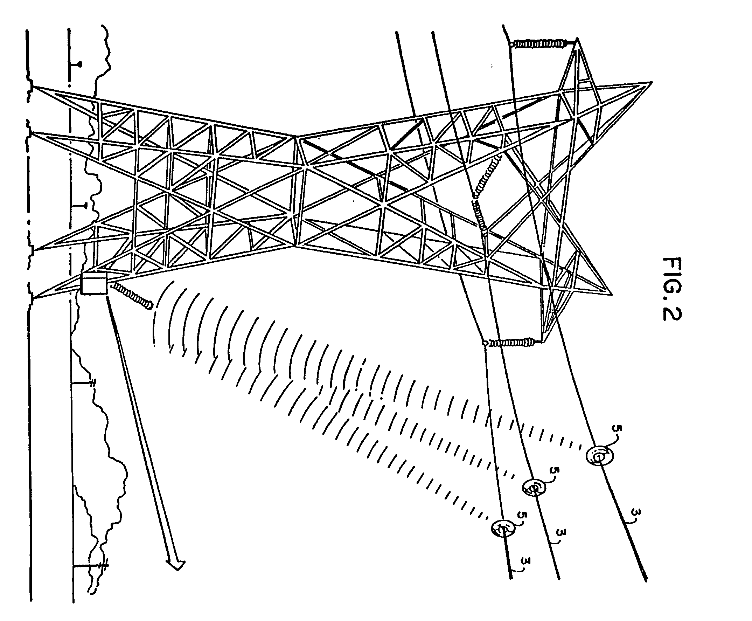

Figure 2 is a perspective view showing how three modules as shown in Figure 1 may be mounted to the three conductors typically associated with a three phase power circuit of a power line;

Figure 3 is a front view, partially in phantom, of the jaws inserts according to our invention for the hub of the toroidal module where it contacts the power line conductor;

Figure 4 is a left side view of the jaws insert of Figure 3;

Figure 5 is a view of one of the jaws inserts taken along the line 5-5 of Figure 3;

· Figure 6 is an exploded perspective view of one of the jaws inserts of Figure 5;

Figure 7 is a front view, partially cut away, of the jaws inserts of Figure 3 inserted in the hub of the toroidal module of Figure 1;

Figure 8 is a partial cross sectional view taken along the line 8-8 of Figure 7;

Figure 9 is a partial cross sectional view similar to Figure 8 showing the connection between the voltage sensor and the structure contacting the power conductor;

Figure 10 is a schematic electrical circuit diagram of the circuits contained within the module shown in Figure 1;

Figures 11 and 12 are diagrammatic representations of the electrical relationship between the various electronic elements used in sensing the potential difference between the power line and ground.

The same reference characters refer to the same elements throughout the several views of the drawings.

A hot stick mounted voltage sensor generally indicated at 5 is shown in Figure 1. The module 5 is generally of a toroidal shape. It comprises a housing 2 to which a jaws assembly, generally indicated at 10, is secured via open radial webs 11. An R.F. impedance matching network 1 is mounted near the assembly 10, and is connected via associated coaxial cable parts 6, 7, and 8 to a shielded transmitter and to electronics 4 inside the module 5. Conductor 32 is connected as described below to the power conductor 3 and to the electronics module 4. Module 4 is connected to the outer conducting skin 2 of the module 5.

Mounted in the webs 11 of housing 2 is the power cable clamping jaws assembly 10. The diameter of the internal opening of this assembly is typically chosen for each specific application so as to accommodate different power cables from 1.27 to 2.54 cm (0.5 to 2″) in diameter.

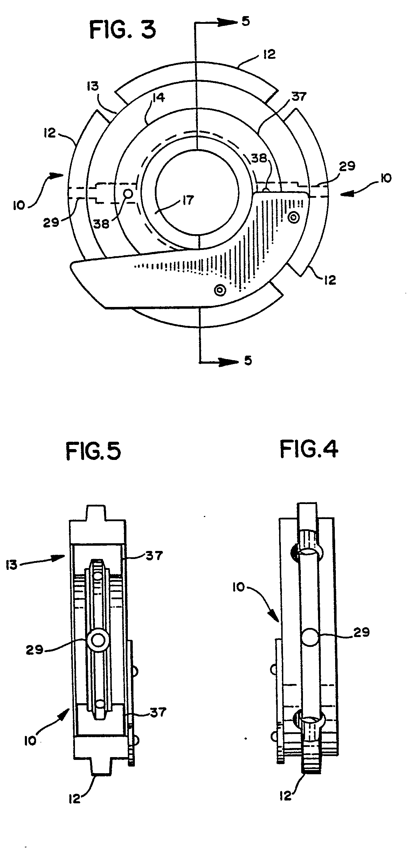

The two metal parts and one conductive resilient part of the cable clamping inserts 10 are shown in detail in Figures 4, 5 and 6. The three parts are:
1) Outer half rings 13
2) Inner half rings 14
3) Conductive resilient neoprene half ring 17.

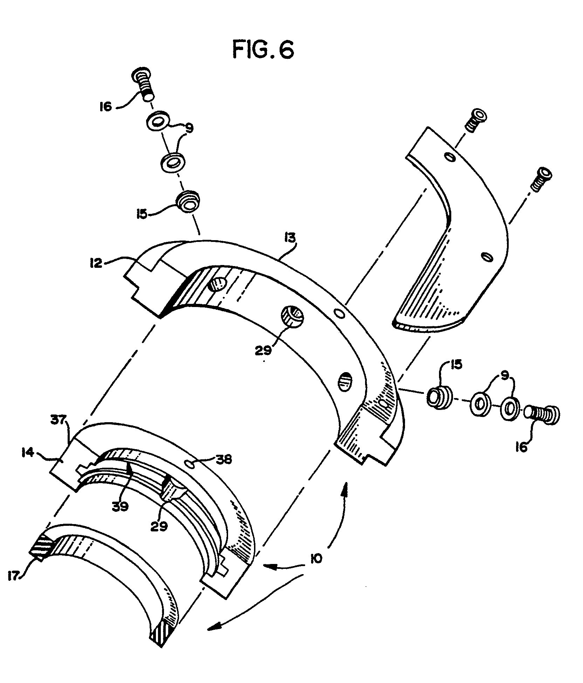

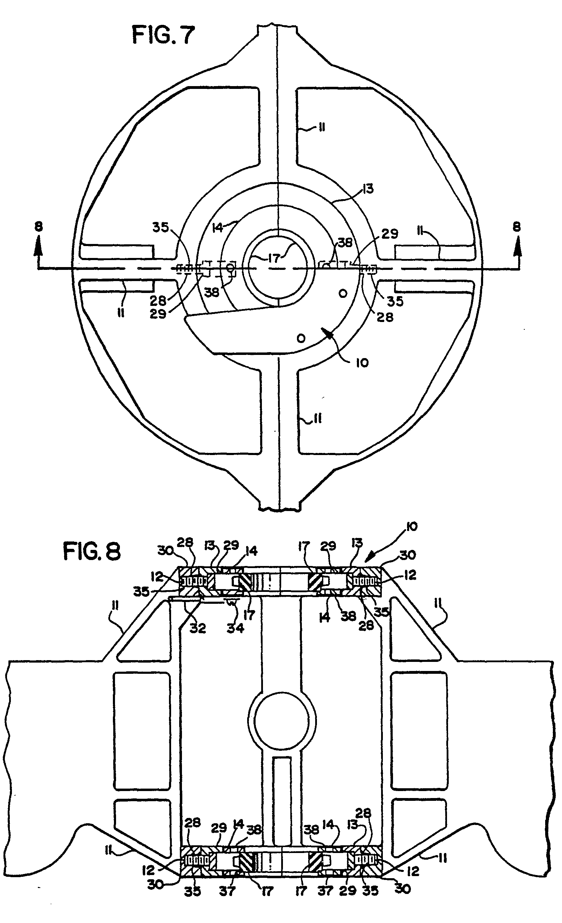

The outer ridge 12 of each of the two outer half rings 13 shown in Figures 4 and 5 engage a similarly machined groove in the adjacent ring 30 of the hub of housing 2 (see Figure 8).

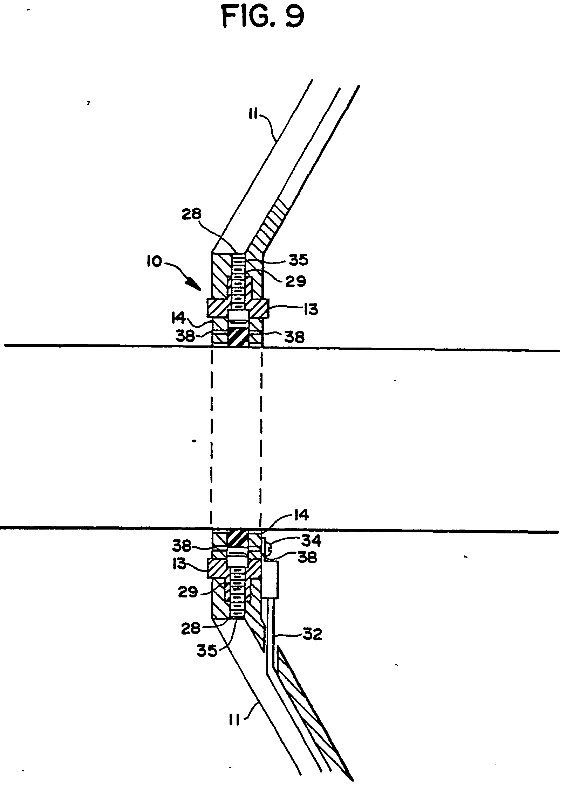

Within outer half rings 13 fit inner half rings 14 as shown in Figure 6. The inner half rings 14 (to which conductor 32 is connected as shown in Figure 9) are electrically insulated from the outer half rings 13 by a hard coat insulating ceramic coating 37 on the outer surfaces of the inner rings 14. This may be formed by an electro deposition process such as anodizing. Alternatively, the coating may be a non-hydroscopic polymer such as the fluorocarbon TEFLON. Referring to Figure 6, bolts 16 connecting outer rings 14 to inner rings 13 are insulated from contact with outer ring by insulating inserts 15, typically made of some solid fluorocarbon such as TEFLON. This insert can tolerate the stress associated with the fastening action of bolts 16 that keep the outer and inner rings in intimate mechanical contact.

A graphite filled, conducting neoprene half ring 17 shown in Figure 6, is shaped so as to resiliently fit within the machined uninsulated space 39 of inner half ring 14 and the power conductor itself. Ring 17 provides a dual function: first, that of conducting a small amount of current to the voltage measuring circuits, and second, that of providing the mechanical friction for preventing the entire assembly 5 from sliding along the power cable in the event of a strong wind.

The electrical lead 32 from voltage sensing circuits is attached to the inner half ring 14 by screw 34 fitted into tapped hole 38 as shown in Figures 6 and 9.

Half ring 14 is fastened to half ring 13 by bolts 16 as shown in Figure 6. Bolts 16 are insulated from the conductive body of 13 by insulators 15 and washers 9. The insulation of bolts 16 insures that the effectiveness of hardcoat insulation 37 is preserved and that no low resistance path exists between half rings 13 and 14.

Half ring 13 is fastened onto ring 30 web structure 11 by bolts 35. Bolts 35 are inserted after half ring 14 is attached to half ring 13 through clearance hole 29. Bolts 35 engage threaded hole 28 in ring 30, part of web 11. Since the bottom part of clearance hole 29 is of smaller diameter than the top part, a shoulder is formed where the head of bolts 35 press against the body of ring 13 to fasten it against ring 30. The action of bolts 35 precludes any motion of machined surface 12 within the receptor ring 30.

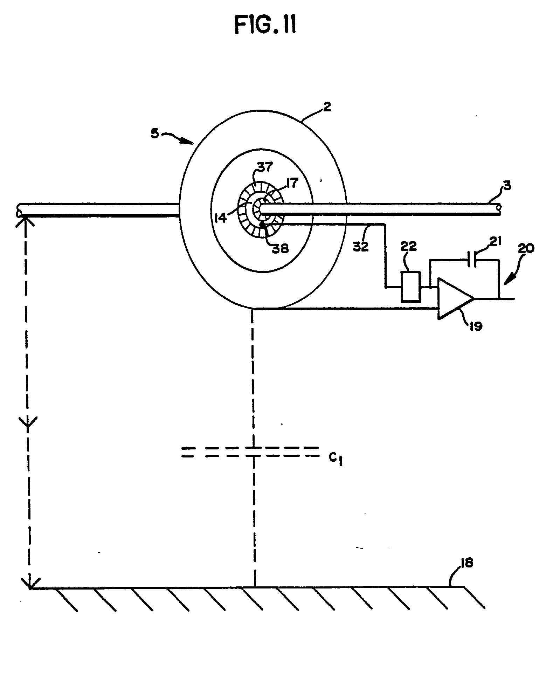

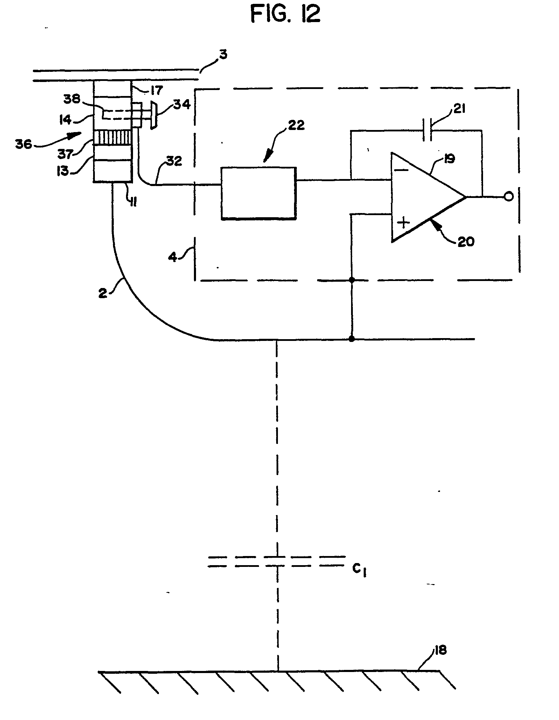

The operation of the voltage sensing circuits may be understood with reference to Figures 11 and 12. In Figure 11 it is desired to measure the potential difference V between power conductor 3 and ground 18. The outer skin 2 of the module 5 forms a capacitor $C_1$ between itself and ground. An integrator, generally indicated at 20, consisting of operational amplifier 19 and capacitor 21 is connected between the power conductor 3 and outer skin 2 of module.

The low input impedance of integrating configuration of operational amplifier 19, and its high gain insures that the potential of outer skin 2 very nearly the same as that of conductor 3. Now the potential between outer skin 2 and ground 18 is the potential V between ground 18 and high voltage conductor 3. Therefore, the current in equivalent capacitance C1 is now directly proportional to the voltage V. Therefore, the current output of the low input impedance integrator formed by operational amplifier 19 and integrating capacitor 21 will provide an AC output voltage exactly proportional to the current in capacitance $C_1$ and thus directly proportional to the high voltage V between conductor 3 and ground 18.

Now referring to figure 12, all of the circuitry needed to perform the voltage conversion and the mechanical structure associated with these components is shown diagrammatically. All of the circuitry included in the integrator connected operational amplifier 20 is mounted within a metal housing 4 internal to the toroidal module 5, also shown in Figure 1, which is mechanically and electrically connected to the outer skin 2 of the module 5. The non-inverting side of the operational amplifier 19 is connected directly to the metal housing 4, while the inverting side is connected to a surge limiting network 22 whose input is connected to the power line via wire lead 32, bolt 34 mounted into tapped hole 38, the metal body of ring 14 and conductive neoprene rings 17. Outer case 2 of the toroidal module 5 is insulated from power line conductor 3 by the interposition of hard coat insulation 37 between rings 13 and 14. This insulation forces any electrical charge flowing from conductor 3 through skin 2 to ground 18 to pass through integrator 20. The capacitance 36 formed across insulation 37 by the presence of metal rings 13 and 14 is shunted by the low input impedance of integrator 20. Therefore, at low operating frequencies of a few hundred Hertz, as typically found on power lines, capacitor 36 appears as a virtual open circuit across the very low input impedance of integrator 20. The action of the integrator 20 is to force the voltage across insulator 37 and therefore capacitance 36 to a fraction of a volt.

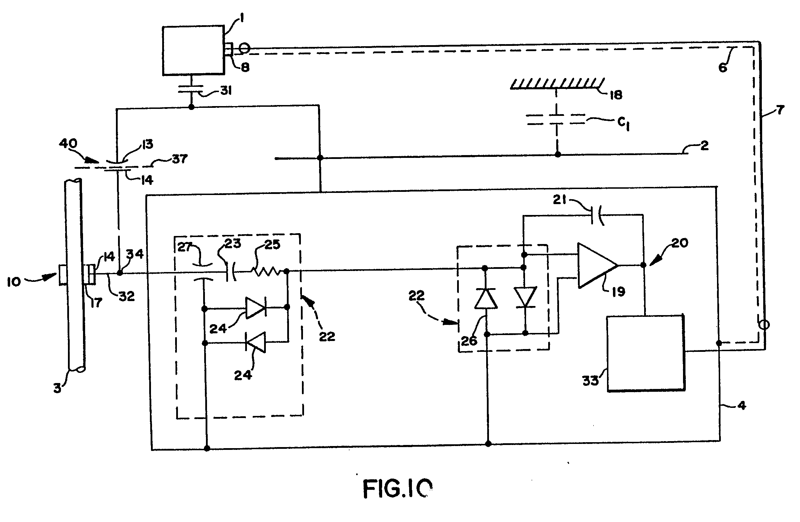

Figure 10 gives further detail about the structure of the surge limiting network 22 comprising:

1) a non-polar electrolytic direct current (D.C.) blocking capacitor 23 to block any, stray DC current components, of sufficiently large capacitance to be electrically transparent at power line frequencies.

2) a current limiting resistor 25 chosen to limit the current through diodes 26 in the event of voltage surges, typically 100 ohms.

3) two crossconnected clamping diodes 24 such as a IN4003 to prevent voltage surges across resistor 25 from exceeding about 1 volt.

4) a feedthrough capacitor 27 designed to shunt to ground fast risetime voltage surges of either polarity.

The capacitance formed by the insulation 37 between half rings 13 and 14 in Figures 8 and 9 is shown in Figure 10 as equivalent capacitor 40. The function of this capacitor is to couple the outer skin 2 of the module 5 and power conductor 3 at high frequencies such as those put out by transmitter 33, through coaxial cable components 6, 7, connector 8, and into space via an impedance matching network 1. Capacitance 31 is created by the proximity of the impedance matching network to the outer skin 2 of module 5 and is used to resonate the outer skin 2 at the frequency of interest, typically 950 MHZ. Note that the presence of capacitor 40 does not influence the current to voltage conversion function of operational amplifier 19 or the accuracy of its voltage measuring function.

The D.C. and low frequency insulating characteristic of capacitor 40 forces all leakage current from the outer skin of the module to ground at the power line operation frequency to flow through operational amplifier 19 so it may be transformed into a voltage to be digitized. Since the integrator 20 forces the low power line frequency voltage across capacitance 36 to be only a fraction of a volt, and capacitance 36 is shunted by the low input impedance looking into integrator 20, capacitance 36 has a negligible influence on the voltage measurement function.

It will thus be seen that the objects set forth above, among those made apparent from the preceding description, are efficiently attained and, since certain changes may be made in the above construction, it is intended that all matter contained in the above description, or shown in the accompanying drawings, shall be interpreted as illustrative and not in the limiting sense.

## Claims

1. Apparatus (5) for measuring a parameter of an above ground power line conductor (3) comprising an electrically conductive housing (2) attached to said above ground conductor, and mounting means (10) for attaching said housing to said conductor; characterized in that said mounting means includes a first conductive portion (14) in electrical contact with said conductor, and a second conductive portion (13) in electrical contact with said housing (2), and electrical insulating means (37) separating said first (14) and second (13) portions,

said apparatus including low impedance current measuring means (20), said measuring means electrically connected to said first conductive portion (14) and to said housing (2) whereby said housing acts as a charge collecting plate and said measuring means measures current flowing from said conductor (3) to said housing (2), said current being proportional to the voltage on said power line conductor.

2. Apparatus as defined in Claim 1 characterized in that said mounting means comprises:

a pair of arcuate nested metal parts including an outer ring (13) and an inner ring (14) fitting within said outer ring; and

a film of insulating material (37) affixed to said inner ring to electrically insulate said inner ring from said outer ring.

3. Apparatus as defined in Claim 2 characterized in that said film is a hard coat ceramic.

4. Apparatus as defined in Claim 2 characterized in that said film is a polymer.

5. Apparatus as defined in Claim 4 characterized in that said film is a fluorocarbon.

6. Apparatus as defined in Claim 2 further including a conductive neoprene insert (17) fitting in said inner ring and contacting said conductor when said housing is mounted on said conductor.

7. Apparatus as defined in Claim 6 characterized in that said housing is generally toroidal in shape and surrounds said conductor when mounted on said conductor.

8. Apparatus as defined in Claim 1 characterized in that said measuring means comprises an operational amplifier (19) with first and second inputs.

9. Apparatus as defined in Claim 8 further including a surge suppressing network connected between said first amplifier input and said conductor, said second amplifier input connected to said housing.

10. Apparatus as defined in Claim 8 characterized in that said operational amplifier is configured as an integrator.

**Patentansprüche**

1. Gerät (5) zur Messung eines Parameters eines oberirdischen Starkstromleiters (3), mit einem elektrisch leitfähigen Gehäuse (2), das an dem oberirdischen Leiter befestigt ist, und mit Befestigungsmitteln (10), um das Gehäuse an dem Leiter zu befestigen; dadurch gekennzeichnet, daß die Befestigungsmittel ein erstes leitendes Teil (14) in elektrischem Kontakt mit dem Leiter und ein zweiters leitendes Teil (13) in elektrischem Kontakt mit dem Gehäuse (2) und einen elektrisch isolierenden Körper (37) umfassen, der das erste (14) und zweite (13) Teil trennt, wobei das Gerät ein Strommeßglied (20) kleiner Impedanz enthält, das elektrisch mit dem ersten leitenden Teil (14) und dem Gehäuse (2) verbunden ist, wobei das Gehäuse als eine Ladungssammelplatte wirkt und das Meßglied den Strom mißt, der von dem Leiter (3) zu dem Gehäuse (2) fließt, wobei der Strom proportional zur Spannung an dem Starkstromleiter ist.

2. Gerät nach Anspruch 1, dadurch gekennzeichnet, daß die Befestigungsmittel umfassen:

ein Paar von bogenförmigen, ineinandergeschachtelten Metallteilen mit einem äußeren Ring (13) und einem inneren Ring (14), der in den äußeren Ring paßt; und einen Film aus Isoliermaterial (37), der an dem inneren Ring befestigt ist, um den inneren Ring von dem äußeren Ring elektrisch zu isolieren.

3. Gerät nach Anspruch 2, dadurch gekennzeichnet, daß der Film eine harte Keramikschicht ist.

4. Gerät nach Anspruch 2, dadurch gekennzeichnet, daß der Film aus einem Polymer besteht.

5. Gerät nach Anspruch 4, dadurch gekennzeichnet, daß der Film ein Fluorkohlenstoff ist.

6. Gerät nach Anspruch 2, das weiter einen leitenden Neopreneinsatz (17) enthält, der in den inneren Ring paßt und den Leiter kontaktiert, wenn das Gehäuse auf dem Leiter montiert ist.

7. Gerät nach Anspruch 6, dadurch gekennzeichnet, daß das Gehäuse im wesentlichen ringförmig ist und den Leiter umgibt, wenn es auf dem Leiter montiert ist.

8. Gerät nach Anspruch 1, dadurch gekennzeichnet, daß das Meßglied einen Operationsverstärker (19) mit ersten und zweiten Eingängen umfaßt.

9. Gerät nach Anspruch 8, das weiter eine Überschlags-Unterdrückungsschaltung aufweist, die zwischen dem ersten Verstärkereingang und dem Leiter angeschlossen ist, wobei der zweite Verstärkereingang mit dem Gehäuse verbunden ist.

10. Gerät nach Anspruch 8, dadurch gekennzeichnet, daß der Operationsverstärker als ein Integrator ausgelegt ist.

**Revendications**

1. Appareil de mesure d'un paramètre d'un fil aérien haute tension (3) comprenant un boîtier électroconducteur (2) monté sur ledit fil aérien, et des moyens de montage (10) pour monter ledit boîtier sur ledit fil, caractérisé en ce que lesdits moyens de montage (10) comprennent une première portion conductrice (14) en contact électrique avec ledit fil, et une seconde portion conductrice (13) en contact électrique avec ledit boîtier (2), et des moyens d'isolation électrique (37) séparant lesdites première (14) et seconde (15) portions,

ledit appareil comprenant des moyens (20) de mesure du courant de basse impédance, ledits moyens de mesure étant en connexion conductrice avec ladite première portion conductrice (14) et avec ledit boîtier (2), grâce à quoi ledit boîtier agit comme plaque collectrice de charges et lesdits moyens de mesure mesurent le courant passant dudit fil (3) audit boîtier (2), ledit courant étant proportionnel à la tension sur ledit fil haute tension.

2. Appareil selon la revendication 1, caractérisé en ce que lesdits moyens de montage comprennent:

deux parties métalliques arquées emboîtées comprenant un anneau externe (13) et un anneau interne (14) s'insérant dans ledit anneau externe, et

une mince couche de matériau isolant (37) apposée sur ledit anneau interne pour isoler électriquement ledit anneau interne dudit anneau externe.

3. Appareil selon la revendication 2, caractérisé en ce que ladite couche est une céramique dure.

4. Appareil selon la revendication 2, caractérisé en ce que ladite couche est un polymère.

5. Appareil selon la revendication 4, caractérisé en ce que ladite couche est un hydrocarbure fluoré.

6. Appareil selon la revendication 2, comprenant en outre un insert (17) conducteur en néoprène s'insérant dans ledit anneau intérieur et établissant un contact avec ledit fil lorsque ledit boîtier est placé sur ledit fil.

7. Appareil selon la revendication 6, caractérisé en ce que ledit boîtier est de forme toroïdale de manière générale et entoure ledit fil lorsqu'il est placé sur ledit fil.

8. Appareil selon la revendication 1, caractérisé en ce que lesdits moyens de mesure comprennent un amplificateur asservi (19) avec une première et une seconde entrées.

9. Appareil selon la revendication 8, comprenant en outre un réseau 22 limitateur de surtension connecté entre ladite première entrée de l'amplificateur et ledit fil, ladite seconde entrée de l'amplificateur étant connectée audit boîtier.

10. Appareil selon la revendication 8, caractérisé en ce que ledit amplificateur asservi adopte la forme d'un intégrateur.

EP 0 181 054 B1

FIG. 1

FIG. 2

FIG. 3

FIG.5

FIG.4

FIG. 6

FIG.7

FIG.8

# FIG. 9

FIG.IC

FIG. 11

## FIG. 12